# EUROPEAN PATENT SPECIFICATION

(11) **EP 2 462 630 B1**
(45) Date of publication and mention of the grant of the patent: **30.03.2016**
(21) Application number: 09777615.7
(22) Date of filing: 03.08.2009
(51) Int. Cl.: H01L 31/107, H01L 27/144

(54) **HIGHLY EFFICIENT CMOS TECHNOLOGY COMPATIBLE SILICON PHOTOELECTRIC MULTIPLIER**
HOCHEFFIZIENTER, MIT CMOS-TECHNOLOGIE KOMPATIBLER FOTOELEKTRISCHER SILICIUMMULTIPLIKATOR
MULTIPLIEUR PHOTOÉLECTRIQUE EN SILICIUM, HAUTEMENT EFFICACE, COMPATIBLE AVEC LA TECHNOLOGIE CMOS

(43) Date of publication of application: 13.06.2012
(73) Proprietor: Max-Planck-Gesellschaft zur Förderung der Wissenschaften e.V., 80539 München (DE)
(72) Inventor: TESHIMA, Masahiro, 85716 Unterschleissheim (DE); MIRZOYAN, Razmik, 85716 Unterschleissheim (DE); DOLGOSHEIN, Boris, Anatolievich, Moscow 115522 (RU); PLESHKO, Anatoly, 117216 Moscow (RU)
(74) Representative: Graf Lambsdorff, Matthias
(86) International application number: PCT/EP2009/005609
(87) International publication number: WO 2011/015206

(56) References cited:
- EP-A1- 1 755 171
- JP-A- 2008 103 614
- US-A- 5 596 186
- SADYGOV Z ET AL: "Three advanced designs of micro-pixel avalanche photodiodes: Their present status, maximum possibilities and limitations" NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL, vol. 567, no. 1, 1 November 2006 (2006-11-01), pages 70-73, XP025056291 ISSN: 0168-9002 [retrieved on 2006-11-01]
- SCIACCA E ET AL: "Silicon planar technology for single-photon optical detectors" IEEE TRANSACTIONS ON ELECTRON DEVICES IEEE USA LNKD- DOI:10.1109/TED.2003.812095, vol. 50, no. 4, April 2003 (2003-04), pages 918-925, XP002575716 ISSN: 0018-9383

## Description

### FIELD OF THE INVENTION

The invention relates to the field of semiconductor optoelectronic devices, particularly to photodetectors with high efficiency of light detection, including the visible part of the spectrum. The photodetectors according to the invention can be used in a wide field of applications, which employ the detection of very weak and fast optical signals as, for example, industrial and medical tomography, life science, nuclear, particle and astroparticle physics etc.

### BACKGROUND OF THE INVENTION

SCIACCA E ET AL: "Silicon planar technology for single-photon optical detectors",
IEEE TRANSACTIONS ON ELECTRON DEVICES IEEE USA LNKD-DOI:10.1109/TED.2003.812095,
vol. 50, no. 4, April 2003 (2003-04), pages 918-925, discloses an avalanche photodiode.

The device for single-photon detection is known as a Single Photon Avalanche Detector-SPAD [e.g. "Avalanche photodiodes and quenching circuits for single-photon detection", S. Cova, M. Ghioni, A. Lacaita, C. Samori and F. Zappa in APPLIED OPTICS vol. 35 No. 12, 20 April 1996, and E. Sciacca, A. Gi-udice, D. Sanfilippo, F. Zappa, S. Lombardo, R. Concentino, C. Di Franco, M. Ghioni, G. Fallica, G. Bonanno, S. Cova, E. Rimini "Silicon Planar Technology for Single-Photon Optical Detectors", IEEE Transactions on electron devices, vol. 50, No.4, April 2003], the known device comprises a silicon substrate with an epitaxial layer made on it, said layer having on a surface a small (10-200 microns) region (a cell) of conductive type that is opposite to the given layer conductive type. The cell is supplied with reverse bias that exceeds breakdown voltage. When a photon is absorbed in this region the Geiger discharge takes place, said discharge is limited with an external quenching resistor.

Such a single-photon detector (SPAD) has a very small area or volume, and also it is not able to measure the light flux intensity.

In order to eliminate these defects it is necessary to use a large number (= 10³) of such cells located on a common substrate having an area equal to or larger than 1 mm². In this case each cell works as the above described photon detector and the device as a whole detects light intensity that is proportional to the number of the worked cells.

Such type of device - the Silicon Photomultiplier(SiPM) - is described in patent RU 2004113616 with a priority 05.05.2004 and European Patent Application EP 1 755 171 A1, pub. 21.02.2007 "Silicon Photomultiplier (variants) and cell therefore" - and accepted as the nearest prior art for present invention. The SiPM comprises a silicon substrate, a plurality of cells the sizes of which are 20-100 microns and which are located on a surface of said substrate in an epitaxial layer; each cell has an internal individual quenching resistor made of high resistance polysilicon and located on top of the silicon oxide layer which covers all cells. The main defects of this device are the following:
- the usage of high resistance polysilicon quenching resistors which is not CMOS-technology compatible;
- the location of polysilicon quenching resistors on top of the silicon oxide layer requires the opening of many (∼ few x 10³) windows in silicon oxide layer for connection of quenching resistor with entrance window silicon layer of the SiPM - that leads to the loss of the photon detection efficiency (PDE) and makes the fabrication process more complicate;
- the presence of epitaxy layer gives rise to the increasing of dark rate of the SiPM and also makes the fabrication process more complicate.

It is therefore an object of the present invention to provide a cell for a silicon-based photoelectric multiplier which is easy and efficient to fabricate and at the same time comprises a high efficiency of light detection in operation.

This object is solved by the features of independent claim 1. Advantageous embodiments are described in the dependent claims.

The present invention provides a cell for a silicon based photodetector having high efficiency in a broad band of wavelengths with a coefficient of amplification up to 10⁷ due to increased cell sensitiveness and significantly reduced dark rate - all that achieved within the framework of CMOS technology. The present invention also provides a silicon based photodetector comprising a plurality of such cells.

One essential idea of the present invention is the fact that the quenching resistor in the cell of the silicon-based photoelectric multiplier is formed essentially in an uppermost layer of the semiconductor body or in other words laterally besides the upper layer of the p-n junction of the device. The quenching resistor layer is thus comprised of a semiconductor layer which is connected to a lateral side face of the upper layer of the p-n junction and which extends in a direction away from the p-n junction to connect the p-n junction with a voltage distribution line. The quenching resistor layer, for example, can be fabricated as a well area in the upper surface of the semiconductor body comprising a dopant concentration in order to yield a desired resistance or resistivity value in order to function as a quenching resistor for quenching the avalanche current. The invention therefore allows to integrate the fabrication of the quenching resistor layer within a CMOS fabrication process.

According to an embodiment also the voltage distribution layers or lines can be integrated within the CMOS fabrication process. The voltage distribution lines can also be fabricated as well areas into the upper surface of the semiconductor body, these well areas comprising comparably high dopant concentration to function as electrically conductive lines.

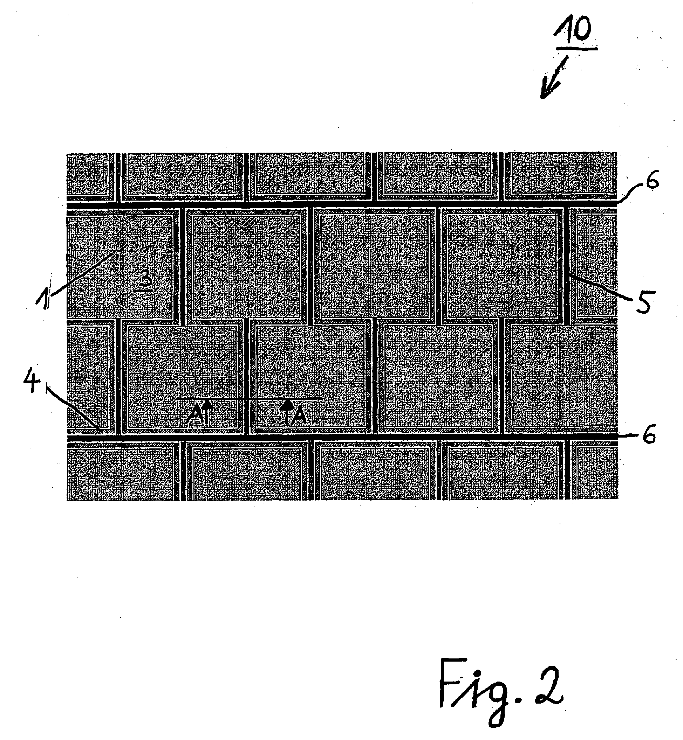

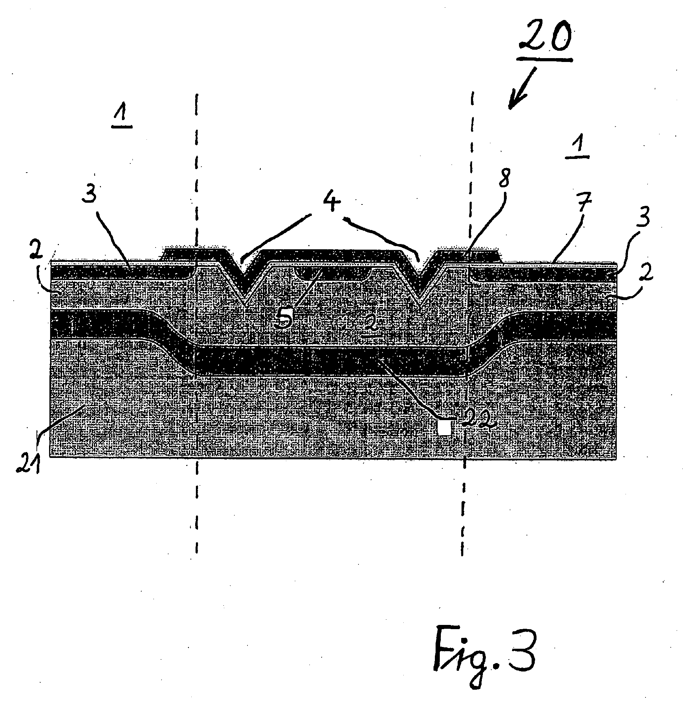

A method of fabricating a silicon-based photoelectric multiplier such as that shown in embodiments of Figs. 2 and 3 could be performed in the form of a complete CMOS fabrication process wherein the fabricating of all layers which are of functional significance of the device would be integrated in the CMOS fabrication process. In particular the process would comprise the steps of providing a silicon substrate, fabricating a first layer of a first conductivity type, fabricating a plurality of second layers of a second conductivity type, and fabricating a plurality of quenching resistor layers and voltage distribution lines, all fabrication steps being conducted preferably by ion implantation processes. Moreover a buried layer of a first conductivity type could be fabricated by a deep ion implantation process.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.
Fig. 1A,B shows a top view representation (A) and a cross-sectional representation (B) of a cell of a silicon-based photoelectric multiplier according to an embodiment;
Fig. 2 shows a top view representation of a section of a silicon-based photoelectric multiplier according to an embodiment;
Fig. 3 shows a cross-sectional representation along line A-A of Fig. 2 of the silicon-based photoelectric multiplier according to an embodiment.

### DETAILED DESCRIPTION OF THE INVENTION

The aspects and embodiments are now described with reference to the drawings, wherein like reference numerals are generally utilized to refer to like elements throughout. In the following description, for purposes of explanation, numerous specific details are set forth in order to provide a thorough understanding of one or more aspects of the embodiments. It may be evident, however, to one skilled in the art that one or more aspects of the embodiments may be practiced with a lesser degree of the specific details. In other instances, known structures and elements are shown in schematic form in order to facilitate describing one or more aspects of the embodiments. The following description is therefore not to be taken in a limiting sense, and the scope is defined by the appended claims. It should also be noted that the representations of the various layers, sheets or substrates in the Figures are not necessarily to scale.

In the following detailed description, reference is made to the accompanying drawings, which form a part thereof, and in which is shown by way of illustration specific embodiments in which the invention may be practiced. In this regard, directional terminology, such as "upper", "lower", "left-hand", "right-hand", "front side", "backside", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention.

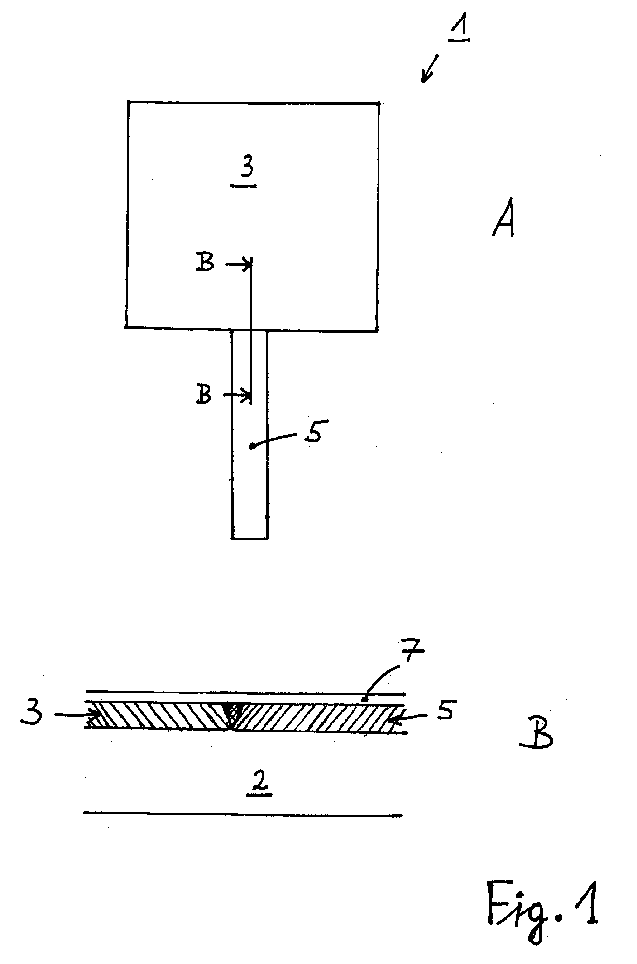

Fig. 1A shows a top view representation of a cell of a silicon-based photoelectric multiplier according to an embodiment and Fig. 1B shows a cross-sectional representation of the cell along line B-B of Fig. 1A.

The cell 1 comprises a layer 2 of a first conductivity type and a layer 3 of a second conductivity type formed on the layer 2 so that the layer 2 and the layer 3 form a first p-n junction. The cell 1 further comprises a quenching resistor layer 5 formed on the layer 2 laterally besides the layer 3 and connected to a lateral side face of the layer 3.

The cell 1 and in particular the layer 3 can have a rectangular or quadratic shape and the quenching resistor layer 5 can be connected to one of the side edges of the layer 3, in particular in the center of the side edge. The quenching resistor layer 5 extends in a direction away from the layer 3 to make electrical contact to a voltage distribution line (not shown) remote from the layer 3. The cell 1 can also comprise an insulation layer 7 covering the layer 2, the layer 3 and the quenching resistor layer 5. The insulation layer 7 can be such that it covers the whole matrix of cells with only one opening at an edge portion of the device for the purpose of electrically contacting the voltage distribution line. The layer 3 and the quenching resistor layer 5 can be formed as well areas into the layer 2 by using conventional ion implantation processes as known in CMOS fabrication technology. As can be seen in Fig. 1B, the implantation region of the layer 3 is shown left-hatched and the implantation region of the quenching resistor layer 5 is shown right-hatched and an overlap between both regions can be provided when conducting the implantation steps so as to provide for a satisfactory electrical contact between both regions.

It is to be noted that the elements as shown in Fig. 1A are not necessarily to scale as regards their dimensions with respect to each other as well as the geometric dimensions of the elements themselves. For example the quenching resistor layer 5 is shown to have a strip-like shape wherein the strip-like quenching resistor layer 5 can have, for example, a length to width ratio of greater than 10, more preferably greater than 20, more preferably greater than 30. Moreover the ratio of the length of a side edge of the cell 1 or of the layer 3 to the width of the strip-like quenching resistor layer 5 can be, for example, greater than 10, more preferably greater than 20, more preferably greater than 30.

Furthermore the quenching resistor layer 5 can have a resistivity in the range of 10 to 50 KOhm/square. With such a resistivity the quenching resistor layer 5 can efficiently act as a quenching resistor for quenching the avalanche current in operation of the photodiode. The value of the resistivity can be adjusted by the geometric dimensions and the dopant concentration of the quenching resistor layer 5.

The layer 3 can have a relatively high level dopant concentration which can, for example, be in the range of 10¹⁸ to 10¹⁹ cm⁻³.

Fig. 2 shows a top view representation of a section of a silicon-based photoelectric multiplier according to an embodiment.

The photoelectric multiplier 10 depicted in Fig. 2 is comprised of a plurality of cells 1 such as that shown in Figs. 1A,B. They are arranged along rows wherein the cells 1 of one row are laterally displaced with respect to the cells 1 of an adjacent row wherein the displacement can be, for example, half the length of one side edge of a quadratically shaped cell 1.

The photoelectric multiplier 10 can have a plurality of voltage distribution lines 6. In the section of the photoelectric multiplier 10 as shown in Fig. 2 there are shown two voltage distribution lines 6 which are arranged along outer side edges of two adjacent rows of cells 1. The quenching resistor layers 5 of each cell 1 of one row extend in the narrow space between two neighboring cells 1 of an adjacent row and are electrically connected with the voltage distribution line 6 extending along the adjacent row. The voltage distribution lines 6 can also be made of a well area formed within the layer 2. In particular the voltage distribution lines 6 can be formed of well areas having a dopant concentration of about 10¹⁹ cm⁻³ or 5 × 10¹⁸ cm to 5 × 10¹⁹ cm⁻³ so that they function as conductive wires. Thus the fabrication of the voltage distribution lines 6 can also be part of and embedded within the CMOS fabrication process.

Also shown in the top view representation of Fig. 2 are the grooves 4 which surround each one of the cells 1 and which prevent the penetration of secondary Geiger photons from one cell to the adjacent cells. The grooves 4 are shown in more detail in an embodiment of a silicon-based photoelectric multiplier as shown in Fig. 3.

Fig. 3 shows a cross-sectional representation along line A-A of Fig. 2 of the silicon-based photoelectric multiplier according to an embodiment.

The section of the photoelectric multiplier 20 shown in Fig. 3 includes the right part of one cell 1 shown on the left side of the drawing and the left part of a further cell 1 shown on the right side of the drawing and a region in between the adjacent cells 1, the region comprising a quenching resistor layer 5 and grooves 4. The photoelectric multiplier 20 comprises a substrate 21 of a second conductivity type having a relatively low doping agent concentration which can be, for example, in the range of 5 × 10¹³ - 5 × 10¹⁴ cm⁻³ and a buried layer 22 of a first conductivity type having a peak doping agent concentration in the range of 5 × 10¹⁷ - 5 × 10¹⁸ cm⁻³ and a gradient of doping concentration in the order of 10¹⁵ - 10¹⁸ from up to down due to back scattering of implanted ions; such a gradient creates a built-in electric field, said field forces carriers generated by yellow-red photons in the doping gradient region to move into Geiger depletion region to be detected. This leads to the increase of long wavelength photon detection efficiency. The substrate 21 and the buried layer 22 form another N-P junction at an interface between them.

Above the buried layer 22 the plurality of identical cells 1 with the grooves 4 as separating elements between them is located, wherein each cell 1 is formed by the layer 2 and the layer 3. The layer 2 is common for all cells 1 and it is contiguous throughout the photoelectric multiplier 20. The layer 3 is formed as a thin layer of second conductivity type having a relatively high doping agent concentration like, for example, 10¹⁸ to 10¹⁹ cm⁻³, and disposed on top of the layer 2. The layer 3 functions as an entrance window of the photoelectric multiplier 20. The layer 2 and the layer 3 form an N-P junction at an interface between them, wherein in operation a reverse bias voltage is applied to the N-P junction to such an extent that the photodiode operates in the Geiger mode. The thin strip-like silicon quenching resistor layers 5 of second conductance type connect each cell 1 with one of the voltage distribution lines 6 and serve as quenching resistors having a resistance of 10 - 50 KOhm/square. The voltage distribution lines 6 are made of second conductivity type silicon layers having a relatively high doping agent concentration like, for example, about 10¹⁹ cm or 5 × 10¹⁸ cm⁻³ to 5 × 10¹⁹ cm⁻³ of a doping agent concentration. The upper surface of the photoelectric multiplier 20 is covered by an insulation layer 7, in particular a silicon oxide layer, with corresponding antireflection properties at an upper surface thereof. Said strip-like quenching resistor layers 5 and voltage distribution lines 6 are disposed between the layer 2 and the insulation layer 7. The voltage distribution lines 6 are connected together on the periphery of the photoelectric multiplier and there is only a single input power supply contact through a single opening window in the insulation layer 7. Finally a grid-like aluminum layer 8 which is serving for the output of the SiPM signal is disposed on top of the silicon oxide layer.

The photoelectric multiplier 20 according to Fig. 3 is an embodiment of a highly efficient CMOS-technology compatible photoelectric multiplier. The buried layer 22 can be formed by an ion implantation step which can be carried out at an appropriate time in the course of the CMOS fabrication process. Also the other layers like the layer 3, the quenching resistor layers 5 and the voltage distribution lines 6 can be processed by further ion implantation steps at appropriate times in the course of the CMOS fabrication process.

The silicon based photoelectric multiplier 20 thus contains the substrate 21 of the second conductivity type, the buried layer 22 of the second conductivity type, a layer 2 of first conductivity type, a layer 3 of second conductivity type (entrance window), separation elements 4 (triangular grooves) between the cells 1, strip-like quenching resistor layers 5 (quenching resistors) of first conductivity type, voltage distribution buses 6, the insulation layer 7, and the grid-like layer 8 on top of the insulation layer 7.
As an example, the substrate 21 can have p-type (n-type) conductivity, the buried layer 22 can have n-type (p-type) conductivity, the layer 2 can have n-type (p-type) conductivity, the layers 3 can have p-type (n-type) conductivity, and the quenching resistor layers 5 and the voltage distribution lines 6 can have p-type (n-type) conductivity.

It should be noted further that according to the embodiment of Fig. 3 the buried layer 22 is fabricated as a non-planar layer, in particular it is fabricated such that it comprises varying depth throughout the device. In Fig. 3 it can be seen that in areas between the cells 1 the buried layer 22 is located deeper within the substrate as compared to the areas of the cells 1. The reason for this is that the electric field will be higher within the cells 1 as compared to the areas between the cells 1 so that only light which is incident on the cell 1 will be efficiently detected only by cell 1.

The highly efficient light detection in a broad part of the spectrum (300 nm - 700 nm) along with high uniformity of an electrical field is reached in a structure as that shown in Fig. 3, which is made by a CMOS-technology process. A high electric field needed for Geiger-type discharge (voltage above the breakdown value) is created in the N-P junction between the layer 3 (entrance window) and the layer 2.

In addition in the embodiment of Fig. 3, another N-P junction is made between the substrate 21 and the buried layer 22, said junction preventing penetration of photoelectrons, created by secondary photons of the Geiger discharge, into the volume of adjacent cells. The penetration of the secondary Geiger photons into the adjacent cells is also prevented by the separating elements 4 between the cells which also serve as optical barriers and which, for example, can be formed as grooves, in particular triangular V-grooves.

Highly Efficient CMOS-technology compatible photoelectric multipliers according to one of the above embodiments comprise independent cells having 20-100 microns of size, that is, for example, length of one side edge of one cell 1 or layer 3. All the cells are jointed through quenching resistors 5 with voltage distribution buses 6, and the identical bias voltage, exceeding the breakdown voltage, is applied to the cells 1, that provides working in the Geiger mode. The quenched Geiger discharge develops in the active region of the cell when a photon gets there. The quenching, that is stopping the discharge, takes place due to fluctuations of the number of the charge carriers up to zero when the voltage of the p-n boundary drops, due to availability of quenching resistor 5 (current-limiting resistor) in each cell. The current signals from the worked cells are summarized on a common load. The amplification of each cell constitutes up to 10⁷. The spread of amplification value is defined by technological spread of the cell capacity and breakdown voltage of the cell, and constitutes less than 5%. As all the cells are identical, the response of the detector to gentle light flashes is proportional to the number of the worked cells, i.e. to light intensity.

## Claims

1. A cell for a silicon-based photoelectric multiplier, comprising:
- a first layer (2) of a first conductivity type,
- a second layer (3) of a second conductivity type formed on the first layer (2), wherein
- the first layer (2) and the second layer (3) form a first p-n junction, and
- a quenching resistor layer (5) of a second conductivity type fabricated as a well area in the upper surface of the semiconductor body on the first layer (2) laterally besides the second layer (3) and connected to a lateral side face of the second layer (3), the quenching resistor layer (5) being arranged and adapted to quench the avalanche current in operation of the multiplier.

2. A silicon-based photoelectric multiplier, comprising:
a plurality of cells (1) according to claim 1.

3. The silicon-based photoelectric multiplier according to claim 1, further comprising:
at least one voltage distribution layer (6) of a second conductivity type formed on the first layer (2), the quenching resistor layers (5) being connected to the voltage distribution line (6).

4. The silicon-based photoelectric multiplier according to claim 2 or 3, wherein
one or more of the second layers (3), the quenching resistor layers (5) and the voltage distribution layers (6) are formed as well areas in the first layer (2), the well areas having respective upper surfaces coplanar with the upper surface of the first layer (2).

5. The silicon-based photoelectric multiplier according to one or more of the preceding claims, wherein
the quenching resistor layer (5) comprises a resistivity in the range of 10 - 50 KΩ/square.

6. The silicon-based photoelectric multiplier according to one or more of the preceding claims, wherein
the voltage distribution layer (6) comprises a doping concentration in a range of 5 × 10¹⁸ cm⁻³ to 5 × 10¹⁹ cm⁻³.

7. The silicon-based photoelectric multiplier according to one or more of the preceding claims, wherein
the second layer (3) comprises a doping concentration in a range of 10¹⁸ cm⁻³ to 10¹⁹ cm⁻³.

8. The silicon-based photoelectric multiplier according to one or more of the preceding claims, further comprising:
a substrate (21) of the second conductivity type,
a doping buried layer (22) of the first conductivity type,
the substrate (21) and the doping layer (22) forming a second p-n junction,
the plurality of cells (1) being arranged above the doping layer (22).

9. The silicon-based photoelectric multiplier according to claim 8, wherein
the substrate (21) comprises a doping concentration in a range of 10¹³ - 10¹⁴ cm⁻³.

10. The silicon-based photoelectric multiplier according to claim 8 or 9, wherein
the doping buried layer (22) comprises a peak doping concentration in a range of 5 × 10¹⁷ cm⁻³ to 5 × 10¹⁸ cm⁻³ and having a gradient of doping concentration in the order of 10¹⁵ cm⁻³ at the entrance window of the photomultiplier to 10¹⁸ cm⁻³ at the peak concentration.

11. The silicon-based photoelectric multiplier according to one or more of the preceding claims, wherein
in each cell (1) the second layer (3) is surrounded by a groove (4) formed into the first layer (2).

12. A silicon-based photoelectric multiplier according to one or more of the preceding claims, wherein
the second layer (3) comprises rectangular, in particular quadratic shape and the quenching resistor layer (5) is connected to a side edge of the second layer (3).

13. The silicon-based photoelectric multiplier according to one or more of the preceding claims, wherein
the quenching resistor layer (5) of one cell (1) extends laterally between two other cells (1), in particular between side faces of the second layers (3) of two other cells (1).

14. The silicon-based photoelectric multiplier according to one or more of the preceding claims, wherein
the cells (1) being arranged along rows, wherein the cells (1) of a first row are laterally displaced with respect to cells (1) of a second row adjacent to the first row, and
the quenching resistor layer (5) of one cell (1) of the first row extends laterally between two cells (1) of the second row and the quenching resistor layer (5) of one cell (1) of the second row extends laterally between two cells (1) of the first row.

15. The silicon-based photoelectric multiplier according to claim 14, further comprising:
a first voltage distribution layer extending along an outer edge of the first row of cells (1), and
a second voltage distribution layer extending along an outer edge of the second row of cells (1), wherein
the quenching resistor layers (5) of the cells (1) of the first row are connected to the second voltage distribution layer, and
the quenching resistor layers (5) of the cells (1) of the second row are connected to the first voltage distribution layer.

16. The silicon-based photoelectric multiplier according to one or more of the preceding claims, further comprising:
an insulation layer (7) disposed on the first layer (2), the second layer (3) and the quenching resistor layer (5).

17. The silicon-based photoelectric multiplier according to claims 2 and 16, wherein
the insulation layer (7) is also disposed on the at least one voltage distribution layer (6), wherein the insulation layer, (7) comprises a through-connect opening for connecting the voltage distribution layer (6) with an outer electrical contact.

## Patentansprüche

1. Zelle für einen siliziumbasierten photoelektrischen Vervielfacher, welche Folgendes umfasst:
- eine erste Schicht (2) eines ersten Leitfähigkeitstyps,
- eine zweite Schicht (3) eines zweiten Leitfähigkeitstyps, die auf der ersten Schicht (2) ausgebildet ist, wobei
- die erste Schicht (2) und die zweite Schicht (3) einen ersten p-n-Übergang bilden und
- eine Löschwiderstandsschicht (5) eines zweiten Leitfähigkeitstyps, die als ein Wannenbereich in der oberen Fläche des Halbleiterkörpers auf der ersten Schicht (2) lateral neben der zweiten Schicht (3) hergestellt ist und mit einer lateralen Seitenfläche der zweiten Schicht (3) verbunden ist, wobei die Löschwiderstandsschicht (5) dafür eingerichtet und ausgelegt ist, den Lawinenstrom beim Betrieb des Vervielfachers zu löschen.

2. Siliziumbasierter photoelektrischer Vervielfacher, welcher Folgendes umfasst:
mehrere Zellen (1) nach Anspruch 1.

3. Siliziumbasierter photoelektrischer Vervielfacher nach Anspruch 2, welcher ferner Folgendes umfasst:
wenigstens eine Spannungsverteilungsschicht (6) eines zweiten Leitfähigkeitstyps, die auf der ersten Schicht (2) ausgebildet ist, wobei die Löschwiderstandsschichten (5) mit der Spannungsverteilungsleitung (6) verbunden sind.

4. Siliziumbasierter photoelektrischer Vervielfacher nach Anspruch 2 oder 3, wobei
eine oder mehrere der zweiten Schichten (3), der Löschwiderstandsschichten (5) und der Spannungsverteilungsschichten (6) als Wannenbereiche in der ersten Schicht (2) ausgebildet sind, wobei die Wannenbereiche jeweilige obere Flächen aufweisen, die mit der oberen Fläche der ersten Schicht (2) koplanar sind.

5. Siliziumbasierter photoelektrischer Vervielfacher nach einem oder mehreren der Ansprüche 2 bis 4, wobei die Löschwiderstandsschicht (5) einen spezifischen Widerstand im Bereich von 10 bis 50 kΩ/Quadrat aufweist.

6. Siliziumbasierter photoelektrischer Vervielfacher nach einem oder mehreren der Ansprüche 2 bis 5, wobei die Spannungsverteilungsschicht (6) eine Dotierungskonzentration im Bereich von 5 x 10¹⁸ cm⁻³ bis 5 x 10¹⁹ cm⁻³ aufweist.

7. Siliziumbasierter photoelektrischer Vervielfacher nach einem oder mehreren der Ansprüche 2 bis 6, wobei die zweite Schicht (3) eine Dotierungskonzentration im Bereich von 10¹⁸ cm⁻³ bis 10¹⁹ cm⁻³ aufweist.

8. Siliziumbasierter photoelektrischer Vervielfacher nach einem oder mehreren der Ansprüche 2 bis 7, welcher ferner Folgendes umfasst:
ein Substrat (21) des zweiten Leitfähigkeitstyps,
eine vergrabene Dotierungsschicht (22) des ersten Leitfähigkeitstyps, wobei das Substrat (21) und die Dotierungsschicht (22) einen zweiten p-n-Übergang bilden,
wobei die mehreren Zellen (1) oberhalb der Dotierungsschicht (22) angeordnet sind.

9. Siliziumbasierter photoelektrischer Vervielfacher nach Anspruch 8, wobei
das Substrat (21) eine Dotierungskonzentration im Bereich von 10¹³ - 10¹⁴ cm⁻³ aufweist.

10. Siliziumbasierter photoelektrischer Vervielfacher nach Anspruch 8 oder 9, wobei
die vergrabene Dotierungsschicht (22) eine Spitzendotierungskonzentration im Bereich von 5 x 10¹⁷ cm⁻³ bis 5 x 10¹⁸ cm⁻³ aufweist und einen Gradienten der Dotierungskonzentration in der Größenordnung von 10¹⁵ cm⁻³ am Eintrittsfenster des Photomultipliers bis 10¹⁸ cm⁻³ bei der Spitzenkonzentration aufweist.

11. Siliziumbasierter photoelektrischer Vervielfacher nach einem oder mehreren der vorhergehenden Ansprüche, wobei in jeder Zelle (1) die zweite Schicht (3) von einer in der ersten Schicht (2) ausgebildeten Rille (4) umgeben ist.

12. Siliziumbasierter photoelektrischer Vervielfacher nach einem oder mehreren der vorhergehenden Ansprüche, wobei die zweite Schicht (3) eine rechteckige, insbesondere quadratische Form aufweist und die Löschwiderstandsschicht (5) mit einer Seitenkante der zweiten Schicht (3) verbunden ist.

13. Siliziumbasierter photoelektrischer Vervielfacher nach einem oder mehreren der vorhergehenden Ansprüche, wobei sich die Löschwiderstandsschicht (5) einer Zelle (1) lateral zwischen zwei anderen Zellen (1), insbesondere zwischen Seitenflächen der zweiten Schichten (3) zweier anderer Zellen (1), erstreckt.

14. Siliziumbasierter photoelektrischer Vervielfacher nach einem oder mehreren der vorhergehenden Ansprüche, wobei die Zellen (1) entlang Zeilen angeordnet sind, wobei die Zellen (1) einer ersten Zeile lateral in Bezug auf Zellen (1) einer zweiten an die erste Zeile angrenzenden Zeile versetzt sind und sich die Löschwiderstandsschicht (5) einer Zelle (1) der ersten Zeile lateral zwischen zwei Zellen (1) der zweiten Zeile erstreckt und sich die Löschwiderstandsschicht (5) einer Zelle (1) der zweiten Zeile lateral zwischen zwei Zellen (1) der ersten Zeile erstreckt.

15. Siliziumbasierter photoelektrischer Vervielfacher nach Anspruch 14, welcher ferner Folgendes umfasst:
eine erste Spannungsverteilungsschicht, die sich entlang einer Außenkante der ersten Zeile von Zellen (1) erstreckt, und
eine zweite Spannungsverteilungsschicht, die sich entlang einer Außenkante der zweiten Zeile von Zellen (1) erstreckt, wobei
die Löschwiderstandsschichten (5) der Zellen (1) der ersten Zeile mit der zweiten Spannungsverteilungsschicht verbunden sind, und
die Löschwiderstandsschichten (5) der Zellen (1) der zweiten Zeile mit der ersten Spannungsverteilungsschicht verbunden sind.

16. Siliziumbasierter photoelektrischer Vervielfacher nach einem oder mehreren der vorhergehenden Ansprüche, welcher ferner Folgendes umfasst:
eine Isolationsschicht (7), die auf der ersten Schicht (2), der zweiten Schicht (3) und der Löschwiderstandsschicht (5) angeordnet ist.

17. Siliziumbasierter photoelektrischer Vervielfacher nach Anspruch 2 und 16, wobei
die Isolationsschicht (7) auch auf der wenigstens einen Spannungsverteilungsschicht (6) angeordnet ist, wobei die Isolationsschicht (7) eine Durchgangsverbindungsöffnung zur Verbindung der Spannungsverteilungsschicht (6) mit einem äußeren elektrischen Kontakt umfasst.

## Revendications

1. Cellule pour un multiplicateur photoélectrique à base de silicium, comprenant:
- une première couche (2) d'un premier type de conductivité,
- une deuxième couche (3) d'un deuxième type de conductivité formée sur la première couche (2), dans laquelle
- la première couche (2) et la deuxième couche (3) forment une première jonction p-n, et
- une couche de résistance de coupure (5) d'un deuxième type de conductivité fabriquée comme une zone de puits dans la surface supérieure du corps semi-conducteur sur la première couche (2) latéralement au-delà de la deuxième couche (3) et reliée à une face latérale de la deuxième couche (3), la couche de résistance de coupure (5) étant agencée et adaptée pour couper le courant d'avalanche lors du fonctionnement du multiplicateur.

2. Multiplicateur photoélectrique à base de silicium, comprenant:
une pluralité de cellules (1) selon la revendication 1.

3. Multiplicateur photoélectrique à base de silicium selon la revendication 2, comprenant en outre:
au moins une couche de distribution de tension (6) d'un deuxième type de conductivité formée sur la première couche (2), les couches de résistance de coupure (5) étant reliées à la ligne de distribution de tension (6).

4. Multiplicateur photoélectrique à base de silicium selon la revendication 2 ou 3, dans lequel
une ou plusieurs des deuxièmes couches (3), des couches de résistance de coupure (5) et des couches de distribution de tension (6) sont formées comme des zones de puits dans la première couche (2), les zones de puits ayant des surfaces supérieures respectives coplanaires avec la surface supérieure de la première couche (2).

5. Multiplicateur photoélectrique à base de silicium selon une ou plusieurs des revendications 2 à 4, dans lequel la couche de résistance de coupure (5) présente une résistivité dans la gamme de 10 - 50 KW/carré.

6. Multiplicateur photoélectrique à base de silicium selon une ou plusieurs des revendications 2 à 5, dans lequel la couche de distribution de tension (6) présente une concentration de dopage dans une gamme de 5 x 10¹⁸ cm⁻³ à 5 x 10¹⁹ cm⁻³.

7. Multiplicateur photoélectrique à base de silicium selon une ou plusieurs des revendications 2 à 6, dans lequel la deuxième couche (3) présente une concentration de dopage dans une gamme de 10¹⁸ cm⁻³ à 10¹⁹ cm⁻³.

8. Multiplicateur photoélectrique à base de silicium selon une ou plusieurs des revendications 2 à 7, comprenant en outre:
un substrat (21) du deuxième type de conductivité,
une couche de dopage enterrée (22) du premier type de conductivité,
le substrat (21) et la couche de dopage (22) formant une deuxième jonction p-n,
la pluralité de cellules (1) étant agencée au-dessus de la couche de dopage (22).

9. Multiplicateur photoélectrique à base de silicium selon la revendication 8, dans lequel
le substrat (21) présente une concentration de dopage dans une gamme de 10¹³ - 10¹⁴ cm⁻³.

10. Multiplicateur photoélectrique à base de silicium selon la revendication 8 ou 9, dans lequel
la couche de dopage enterrée (22) présente une concentration de dopage maximale dans une gamme de 5 x 10¹⁷ cm⁻³ à 5 x 10¹⁸ cm⁻³ et a un gradient de concentration de dopage de l'ordre de 10¹⁵ cm⁻³ à la fenêtre d'entrée du photomultiplicateur à 10¹⁸ cm⁻³ à la concentration maximale.

11. Multiplicateur photoélectrique à base de silicium selon une ou plusieurs des revendications précédentes, dans lequel dans chaque cellule (1), la deuxième couche (3) est entourée par un sillon (4) formé dans la première couche (2).

12. Multiplicateur photoélectrique à base de silicium selon une ou plusieurs des revendications précédentes, dans lequel la deuxième couche (3) présente une forme rectangulaire, en particulier quadratique et la couche de résistance de coupure (5) est reliée à un bord latéral de la deuxième couche (3).

13. Multiplicateur photoélectrique à base de silicium selon une ou plusieurs des revendications précédentes, dans lequel la couche de résistance de coupure (5) d'une cellule (1) s'étend latéralement entre deux autres cellules (1), en particulier entre des faces latérales des deuxièmes couches (3) de deux autres cellules (1).

14. Multiplicateur photoélectrique à base de silicium selon une ou plusieurs des revendications précédentes, dans lequel les cellules (1) sont agencées le long de rangées, les cellules (1) d'une première rangée étant déplacées latéralement par rapport aux cellules (1) d'une deuxième rangée adjacente à la première rangée, et
la couche de résistance de coupure (5) d'une cellule (1) de la première rangée s'étend latéralement entre deux cellules (1) de la deuxième rangée et la couche de résistance de coupure (5) d'une cellule (1) de la deuxième rangée s'étend latéralement entre deux cellules (1) de la première rangée.

15. Multiplicateur photoélectrique à base de silicium selon la revendication 14, comprenant en outre:
une première couche de distribution de tension s'étendant le long d'un bord extérieur de la première rangée de cellules (1), et
une deuxième couche de distribution de tension s'étendant le long d'un bord extérieur de la deuxième rangée de cellules (1), dans lequel
les couches de résistance de coupure (5) des cellules (1) de la première rangée sont reliées à la deuxième couche de distribution de tension, et
les couches de résistance de coupure (5) des cellules (1) de la deuxième rangée sont reliées à la première couche de distribution de tension.

16. Multiplicateur photoélectrique à base de silicium selon une ou plusieurs des revendications précédentes, comprenant en outre :
une couche d'isolation (7) disposée sur la première couche (2), la deuxième couche (3) et la couche de résistance de coupure (5).

17. Multiplicateur photoélectrique à base de silicium selon les revendications 2 et 16, dans lequel
la couche d'isolation (7) est également disposée sur l'au moins une couche de distribution de tension (6), la couche d'isolation (7) comprenant une ouverture d'interconnexion pour relier la couche de distribution de tension (6) à un contact électrique extérieur.
